# EUROPEAN PATENT APPLICATION

(11) **EP 4 064 341 A1**
(43) Date of publication of application: **28.09.2022**
(21) Application number: 21173923.0
(22) Date of filing: 14.05.2021
(51) Int. Cl.: H01L 23/498

(54) **SUBSTRATE WITH CONDUCTIVE PADS AND CONDUCTIVE LAYERS**

(30) Priority: 26.03.2021 US 202117214141
(71) Applicant: Juniper Networks, Inc., Sunnyvale, CA 94089 (US)
(72) Inventor: SU, Peng, Sunnyvale, CA California 94089 (US); AHMED, Omar, Sunnyvale, CA California 94089 (US); GLASAUER, Bernard H., Sunnyvale, CA California 94089 (US)
(74) Representative: D Young & Co LLP

(57) **Abstract**

A substrate structure may include a substrate that includes a set of conductive pads formed below a surface of the substrate. The substrate structure may include a set of conductive layer portions formed over the set of conductive pads, wherein a particular conductive layer portion, of the set of conductive layer portions, extends from a corresponding particular conductive pad, of the set of conductive pads, to at least the surface of the substrate.

## Description

### BACKGROUND

A substrate structure may include horizontally oriented layers of interconnects and vertically oriented vias filled to propagate electric current from a first electrical component to a second electrical component. The substrate structure may use copper as an internal conductor for the horizontally oriented layers of interconnects and the vertically oriented vias. Using copper may reduce propagation delays and power consumption, relative to other metal interconnects, when a semiconductor device that includes the substrate structure is in operation. Moreover, use of copper may enable interconnects with narrower dimensions than may be found on substrate assemblies that use another metal (e.g., aluminum) for interconnects.

### SUMMARY

In some implementations, a substrate structure includes a substrate that includes a set of conductive pads formed below a surface of the substrate; and a set of conductive layer portions formed over the set of conductive pads, wherein a particular conductive layer portion, of the set of conductive layer portions, extends from a corresponding particular conductive pad, of the set of conductive pads, to at least the surface of the substrate.

In some implementations, a substrate structure includes a substrate with a set of electrical traces disposed below a surface of the substrate, wherein the substrate includes a set of solder mask regions extending from the set of electrical traces to the surface of the substrate; and a set of conductive layer portions filling the set of solder mask regions toward the surface of the substrate and electrically connected to the set of electrical traces.

In some implementations, a device includes a substrate structure including a substrate with a first set of solder balls, wherein the substrate structure includes a set of conductive pads formed below a first surface of the substrate, and wherein the substrate structure includes a set of conductive layer portions formed over the set of conductive pads, extending from the set of conductive pads to at least the first surface of the substrate, and to which the first set of solder balls is connected; and an integrated circuit mounted to a second surface of the substrate structure using a second set of solder balls.

In some implementations, a method of manufacturing a semiconductor device includes receiving a substrate that includes a conductive pad below a surface of the substrate; and forming at least one conductive layer on the conductive pad, wherein the at least one conductive layer extends to at least the surface of the substrate, and wherein a solder ball is connectable to the at least one conductive layer.

### BRIEF DESCRIPTION OF THE DRAWINGS

Figs. 1A-1C are diagrams of an example implementation of a device including a substrate structure described herein.
Fig. 2 is a diagram of an example of a substrate described herein.
Figs. 3A-3D are diagrams of example implementations of a conductive pad and a conductive layer described herein.
Figs. 4A-4B are diagrams of characteristics of example implementations of a conductive pad and a conductive layer described herein.
Fig. 5 is a flowchart of an example process for providing a semiconductor device pad configuration that improves electromigration performance of the semiconductor device.

### DETAILED DESCRIPTION

The following detailed description of example implementations refers to the accompanying drawings. The same reference numbers in different drawings may identify the same or similar elements.

As described above, substrates may include horizontally oriented electrical traces (e.g., interconnects) that enable propagation of electric current to, for example, a conductive pad, which is vertically oriented with respect to receiving a solder ball to connect to another electrical component. In other words, a substrate structure may have a "solder joint" at a location where electric current transitions from propagating in a horizontal direction (through copper electrical traces) to propagating in a vertical direction (through, for example, tin-silver alloy solder balls).

Advanced semiconductor devices, such as application-specific integrated circuits (ASICs), are experiencing significant power increases. Such increasing power increases electric current per solder joint, which increases electromigration in the solder joints. Electromigration creates reliability issues for the semiconductor device, and severe electromigration causes open failures (e.g., as a result of pad material diffusion and dissolution) at interfaces between electrical traces, conductive pads, and solder balls (e.g., at the solder joints). Electromigration failures are driven by current density within a material and by an intrinsic resistance to electromigration of the material.

Solder balls (e.g., which may be tin-silver alloy or tin-lead alloy, among other examples) have poor electrical conductivity relative to the copper material used for electrical traces and conductive pads. The change in orientation of electric current flow (e.g., from horizontal through the electrical traces, which are highly conductive, to vertical through the solder balls, which are less conductive) results in a significant increase in current density at a point where the electric current first reaches an interface between an electrical trace and a solder ball and changes flow orientation from horizontal to vertical. This increase in current density can result in electromigration driven failures. Moreover, the tin-silver or tin-lead material of solder balls has a relatively poor intrinsic resistance to electromigration, which may further result in electromigration driven failures.

Thus, current techniques for manufacturing semiconductor devices (e.g., that include the aforementioned substrate assemblies) waste physical resources (e.g., material or energy), computing resources (e.g., processing resources, memory resources, or communication resources), networking resources, or human resources, among other examples, associated with manufacturing replacements for faulty semiconductor devices, correcting open failures in the faulty semiconductor devices, or losing network traffic due to the faulty semiconductor devices, among other examples.

Some implementations described herein provide a substrate structure that includes conductive pads with added conductive layers to improve electromigration performance of a substrate structure and an associated semiconductor device. For example, a substrate structure may include a substrate with a set of conductive pads formed below a surface of the substrate and a set of conductive layer portions formed over the set of conductive pads. In this case, the set of conductive layer portions may be formed from a material, such as copper or another material, that has a better electrical conductivity and a better electromigration performance than a set of solder balls with which electrical components may be attached to the substrate structure.

As a result, when electric current changes flow orientation from horizontal (e.g., through an electrical trace) to vertical (e.g., through a pad, a conductive layer portion, and, eventually, a solder ball), the conductive layer portion spreads the electric current over a greater area, thereby reducing a current density. In this way, based on reducing the current density, the conductive layer reduces a likelihood of failure. Moreover, although some level of current density may still be present in the conductive layer portion, the conductive layer portion reduces a likelihood of failure based on being formed from a material that is more resistant to electromigration than solder. Such a substrate structure enables manufacture of high-power semiconductor devices with reduced electromigration-induced failure. This, in turn, conserves manufacturing resources, computing resources, networking resources, human resources, and/or the like that would otherwise have been consumed in manufacturing replacements for faulty semiconductor devices, correcting open failures in the faulty semiconductor devices, or losing network traffic due to the faulty semiconductor devices, among other examples.

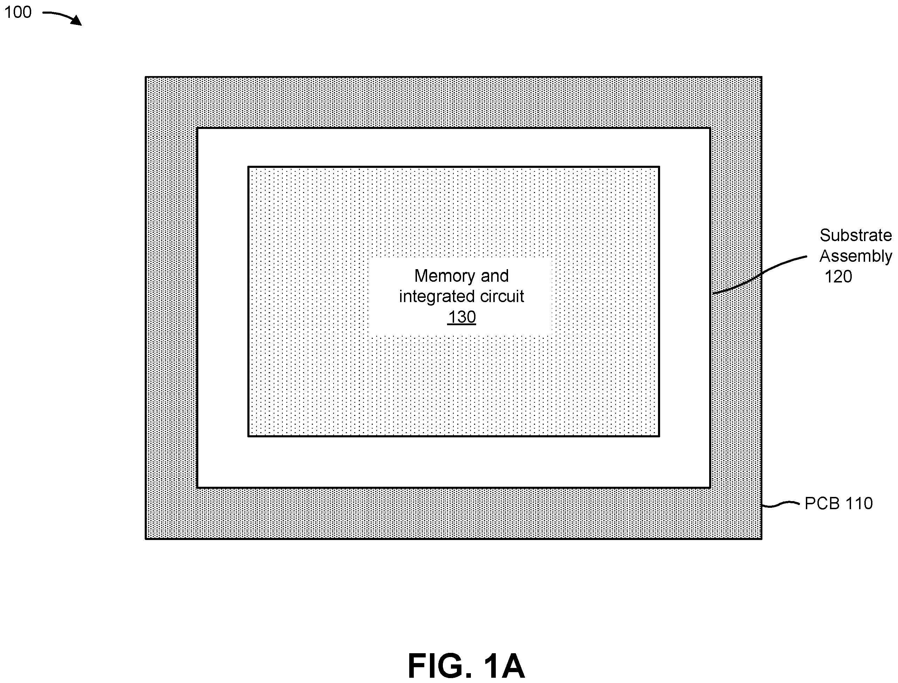

Figs. 1A-1C are diagrams of a device 100. As shown in Fig. 1A, device 100 includes a printed circuit board (PCB) 110, a substrate structure 120, and a memory and integrated circuit 130. Memory and integrated circuit 130 may connect to substrate structure 120 via, for example, a first set of solder balls. Substrate structure 120 may connect to PCB 110 via, for example, a second set of solder balls.

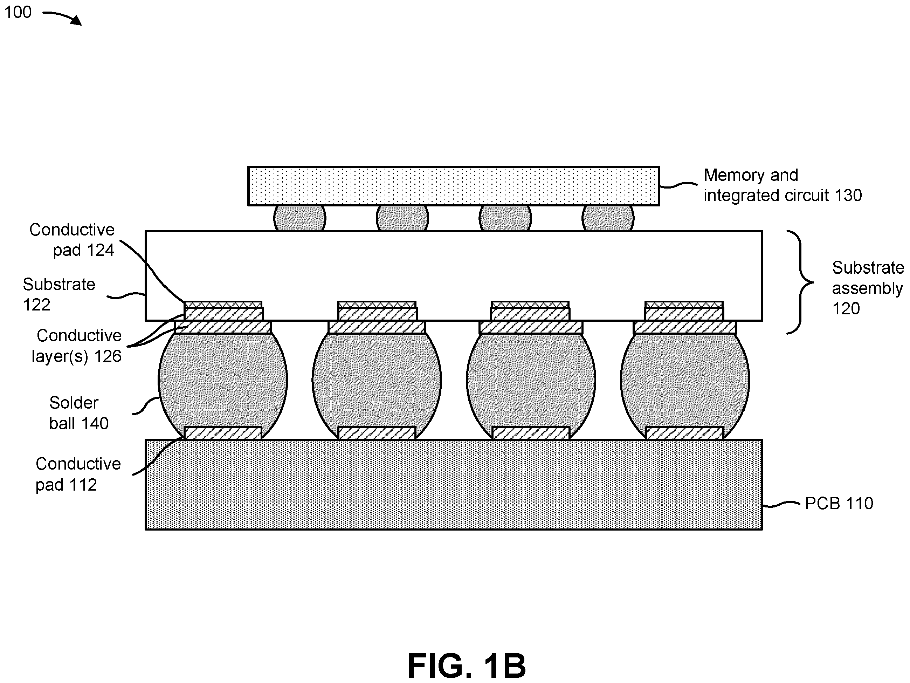

As shown in Fig. 1B, PCB 110 may include a set of conductive pads 112; and substrate structure 120 may include a substrate 122, a set of conductive pads 124, and a set of conductive layers 126 (e.g., which may be divided into sets of one or more conductive layer portions corresponding to each solder ball 140). PCB 110 may attach to substrate structure 120, at a first surface of substrate 122, using solder balls 140 (i.e., the second set of solder balls identified above). Similarly, memory and integrated circuit 130 may attach to substrate structure 120, at a second surface of substrate 122, using another set of solder balls (i.e., the first set of solder balls identified above). Although substrate structure 120 is describe in terms of connecting to PCB 110 and to memory and integrated circuit 130, substrate structure 120 may be provided without PCB 110 and/or memory and integrated circuit 130 attached. Additionally, or alternatively, substrate structure 120 may connect (e.g., via one or more sets of solder balls) to one or more other types of electrical components. For example, rather than memory and integrated circuit 130, substrate structure 120 may connect to a single silicon chip, a combination of multiple silicon chips (e.g., which may include a logic or a memory), or another type of component.

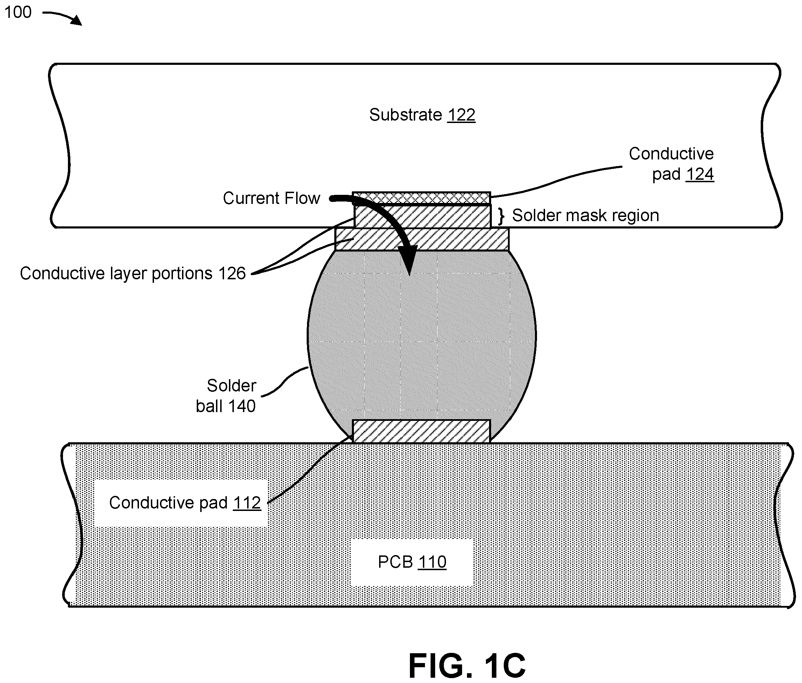

As shown in Fig. 1C, a conductive pad 124 may be disposed below a first (e.g., bottom) surface of substrate 122. As shown, conductive pad 124 may be disposed in a horizontal (or parallel) plane relative to the first surface of substrate 122. Conductive pad 124 is formed of a conductive material, such as copper.

One or more conductive layer portions 126 may be disposed on top of the conductive pad 124 and extending orthogonal to the horizontal plane in which the conductive pad 124 is disposed. The one or more conductive layer portions 126 is/are formed of a conductive material, such as copper.

In some implementations, the one or more conductive layer portions 126 may include a single copper layer portion covering conductive pad 124. In this case, as described in more detail herein, the single copper layer portion at least partially fills a solder mask region formed from an opening in the first surface of substrate 122.

In some implementations, the one or more conductive layer portions 126 may include multiple copper layers, such as a first layer filling the solder mask region and a second layer covering the first layer and a portion of the first surface of substrate 122. In some implementations, one or more additional metallization layer portions may be added to cover the one or more aforementioned copper layer portions, as described in more detail herein. Although the one or more conductive layer portions 126 are shown as multiple discrete layers, a single (monolithic) conductive layer portion 126 may cover conductive pad 124 and/or a portion of the first surface of substrate 122.

When device 100 is in operation, current flow may travel from a horizontal orientation through an electrical trace (not shown) embedded in substrate 122 to conductive pad 124. At an interface between the conductive pad 124 and the one or more conductive layer portions 126, the current flow may transition to travel in a vertical orientation toward a solder ball 140, a conductive pad 112, and one or more electrical traces (not shown) embedded in or on PCB 110. In this case, based on adding the one or more conductive layer portions 126 between conductive pad 124 and solder ball 140 (rather than having the solder ball 140 fill the solder mask region), the one or more conductive layer portions 126 improve current spreading, thereby reducing electromigration and associated failure. Moreover, based on forming the one or more conductive layer portions 126 from a material that resists electromigration better than solder ball 140, a likelihood of electromigration-induced failure is reduced.

As indicated above, Figs. 1A-1C are provided as an example. Other examples may differ from what is described with regard to Figs. 1A-1C. For example, while copper is described as the material used for the one or more conductive layer portions 126, other conductive materials with comparable electrical and/or thermal properties may be used, such as silver or aluminum.

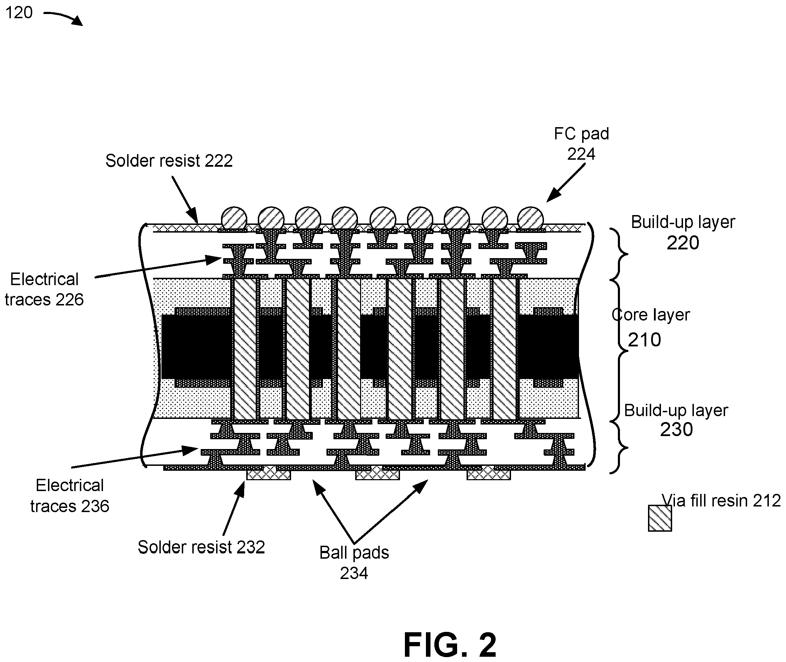

Fig. 2 is a diagram of an example internal structure of substrate structure 120. As shown in Fig. 2, substrate structure 120 may include a core layer 210, first build-up layers 220, and second build-up layers 230. In some implementations, substrate structure 120 may be associated with operation in a flip chip configuration, as shown with regard to other figures herein.

The core layer 210 may include one or more layers of material providing one or more electrical paths between first build-up layers 220 and second build-up layers 230. For example, the core layer 210 may include a set of vias to electrically connect portions of first build-up layers 220 to portions of second build-up layers 230. The set of vias may be formed from a set of vertical openings in core layer 210 that have an electrical conductor, such as copper, forming or covering walls of the set of vertical openings. The set of vias may be filled with via fill resin 212.

First build-up layers 220 may include a layer of solder resist 222 and a flip chip (FC) pad 224. Solder resist 222 and FC pad 224 enable first build-up layers 220 to receive and attach to an electrical component (e.g., a chip with a memory or an integrated circuit, among other examples) in a flip chip configuration. First build-up layers 220 may further include a first set of electrical traces 226. The first set of electrical traces 226 may include a set of copper interconnects to electrically connect FC pad 224 (and a chip mounted thereto) to vias of core layer 210 and onward to second build-up layers 230 (and an electrical component mounted thereto, such as a PCB). As shown, the first set of electrical traces 226 may be disposed in a set of horizontal layers with vertical connections between each layer to enable routing of electric current. In some implementations, the first set of electrical traces 226 may be formed from copper or another electrically conductive material.

Second build-up layers 230 may include a layer of solder resist 232 and a set of ball pads 234. Solder resist 232 and ball pads 234 enable second build-up layers 230 to receive and attach to an electrical component (e.g., a PCB, among other examples). In some implementations, solder resist 232 is a discontinuous layer, such that a set of solder mask openings are formed in a surface of solder resist 232. Each solder mask opening may be at least partially metallized to form a ball pad 234, which may receive a solder ball (or may be covered by one or more conductive layers, which may receive the solder ball, as described in more detail herein). Second build-up layers 230 may further include a second set of electrical traces 236. As shown, the second set of electrical traces 236 may be disposed in a set of horizontal layers with vertical connections between each layer to enable routing of electric current between ball pads 234 and core layer 210 (and to first build-up layers 220 and an electrical component mounted thereto). In some implementations, the second set of electrical traces 236 may be formed from copper or another electrically conductive material. As shown, the second set of electrical traces 236 have a horizontal orientation at ball pads 234, resulting in a horizontal flow of electric current before the electric current turns and flows through solder balls attached thereto (e.g., via one or more conductive layers filling ball pads 234), as described in more detail herein.

As indicated above, Fig. 2 is provided as an example. Other examples may differ from what is described with regard to Fig. 2.

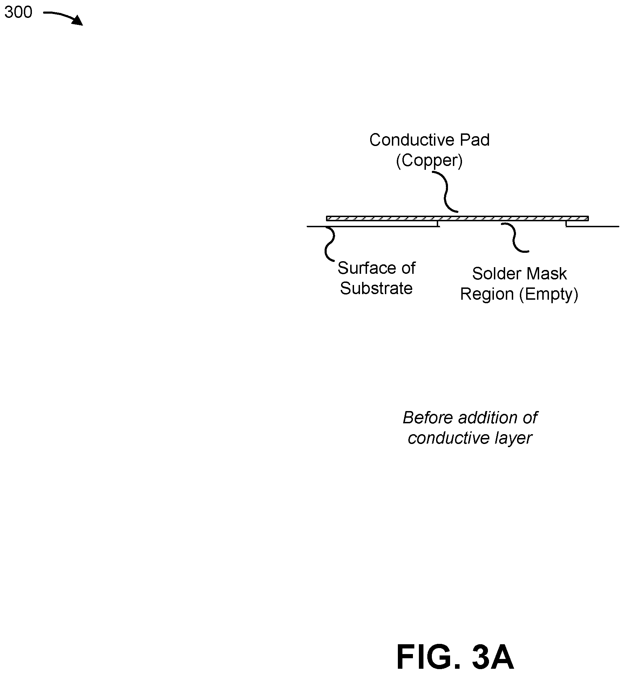

Figs. 3A-3D are diagrams of one or more examples 300/300'/300" of a conductive pad (e.g., conductive pad 124) with a conductive layer (e.g., conductive layer 126). As shown in Fig. 3A, in example 300, before addition of a conductive layer, the conductive pad may be disposed below a surface of a substrate and the surface of the substrate may include an opening forming a solder mask region. In this case, the conductive pad may be copper in a horizontal orientation (resulting in a horizontal flow of electric current through the conductive pad). As described above, the surface of the substrate may be a solder mask material that includes openings to receive solder balls (with one or more intermediate conductive layers), thereby forming the solder mask region. In this case, before addition of a conductive layer, the solder mask region is empty.

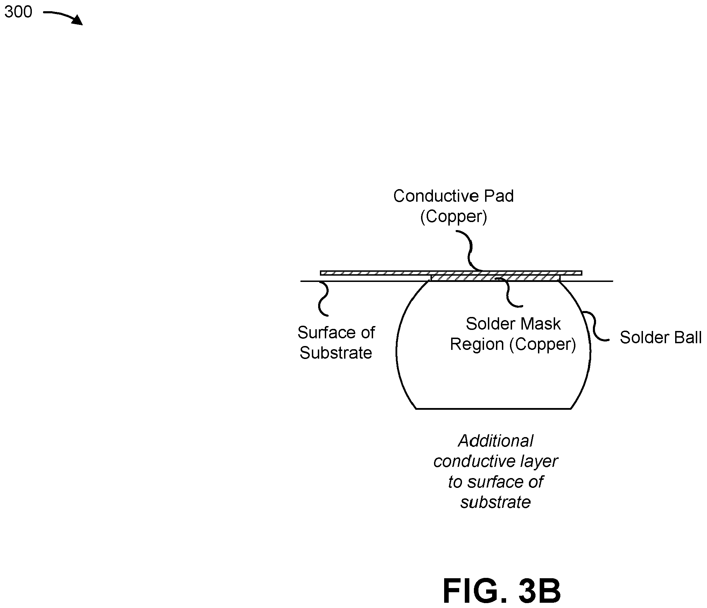

As shown in Fig. 3B, and in example 300, during manufacture, a conductive layer is disposed on a surface of the conductive pad and, in some implementations, a solder ball is disposed onto the conductive layer. For example, the solder mask region may be at least partially filled by the conductive layer from the surface of the conductive pad toward the surface of the substrate and the solder ball may be attached to the conductive layer rather than directly to the conductive pad. In some implementations, the solder mask region may be completely filled by the conductive layer, which may extend to the surface of the substrate.

In this case, electric current flows through the conductive layer and the solder ball with a vertical orientation. As described in more detail above, when the electric current transitions from horizontal flow through the conductive pad to vertical flow through the conductive layer (and the solder ball), the conductive layer spreads the electric current more effectively than solder alone (as a result of a copper conductive layer having a higher electrical conductivity than, for example, a tin-silver or a tin-lead solder ball). In this way, the conductive layer reduces a level of current density, thereby reducing an amount of electromigration and improving reliability. Moreover, the conductive layer may use a material, such as copper, with a greater resistance to electromigration than solder alone, thereby reducing a likelihood of failure from the level of current density that remains at the aforementioned transition.

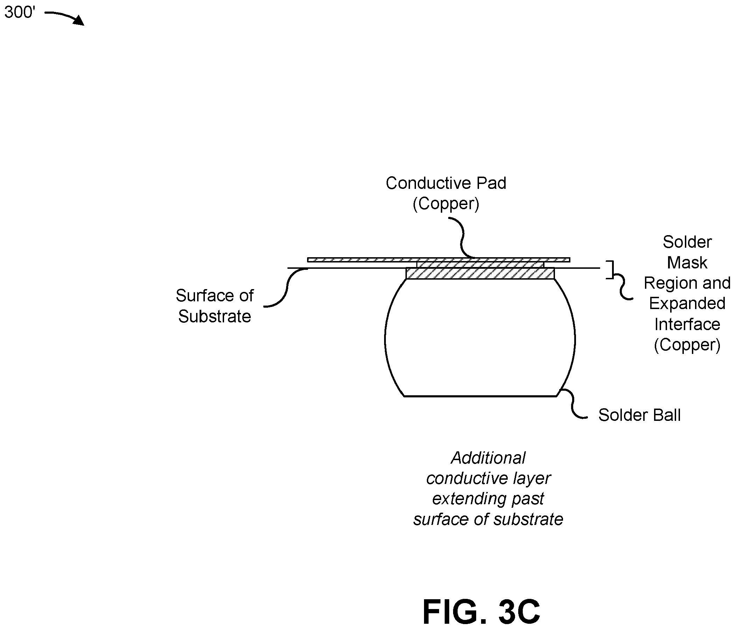

As shown in Fig. 3C, and in example 300', during manufacture, multiple conductive layers are disposed on a surface of the conductive pad to form an expanded interface. For example, the solder mask region may be filled from the surface of the conductive pad to the surface of the substrate with a first conductive layer and a second conductive layer may be formed over the first conductive layer and, in some implementations, over a portion of the surface of the substrate. The first conductive layer may form a "neck" or "neck region" and the second conductive layer may form a "pad." In this case, the solder ball is attached onto the pad formed by the second conductive layer. In some implementations, the first conductive layer and the second conductive layer may be a single material. For example, the first conductive layer may be a copper layer deposited onto the conductive pad (which may be copper) and the second conductive layer may be another copper layer deposited onto the first conductive layer. Alternatively, the first conductive layer and the second conductive layer may be a single, monolithic copper layer. In some implementations, the conductive pad, the first conductive layer, and the second conductive layer may be a single, monolithic copper layer. In some implementations, the conductive pad, the first conductive layer, and/or the second conductive layer may be another material or alloy of materials, such as a silver material, a gold material, a platinum material, an aluminum material, a nickel material, a zinc material, or an alloy material, among other examples.

In some implementations, the conductive layers may be associated with particular thicknesses. For example, the neck, formed by the first conductive layer, may be associated with a thickness equal to a depth of the conductive pad below the surface of the substrate, such as approximately 20 micrometers (µm) or in a range of approximately 5 µm to approximately 40 µm. In some implementations, the pad formed by the second conductive layer may be approximately 20 µm, approximately 40 µm, or approximately 60 µm, as described in more detail herein. The pad may have a width sized to provide spacing between each pad and each associated solder ball. In some implementations, the pad formed by the second conductive layer may have a thickness in a range of approximately 5 µm to approximately 100 µm, a range of approximately 10 µm and approximately 80 µm, or a range of approximately 20 µm to approximately 60 µm. In some implementations, the pad may have a thickness in a range from approximately 0% to approximately 200% greater than a thickness of the neck. A total thickness of layers forming the pad, the neck, and/or an additional metallization layer may be, for example, up to approximately 90% (e.g., a range of 0% and 90%) of a distance between a substrate and a PCB when the substrate and the PCB are attached (and a solder ball may be, for example, 20% or more (e.g., a range of 20% to 100%) of the distance between the substrate and the PCB). In some implementations, the pad may extend over the surface of the substrate such that the pad has a surface area of approximately 200% of a surface area of the neck. In some implementations, the one or more conductive layers may have a thickness of between approximately 100% and approximately 400% of a depth of the conductive pad below the surface of the substrate. In some implementations, the one or more conductive layers may have a thickness of approximately 200% of a thickness of the conductive pad.

Electric current flows through the first conductive layer, the second conductive layer, and the solder ball with a vertical orientation. As described in more detail above, when the electric current transitions from horizontal flow through the conductive pad to vertical flow through the conductive layers (and the solder ball), the conductive layers spread the electric current more effectively than solder alone or a single conductive layer alone. In this way, the conductive layers reduce a current density, thereby reducing an amount of electromigration and improving reliability.

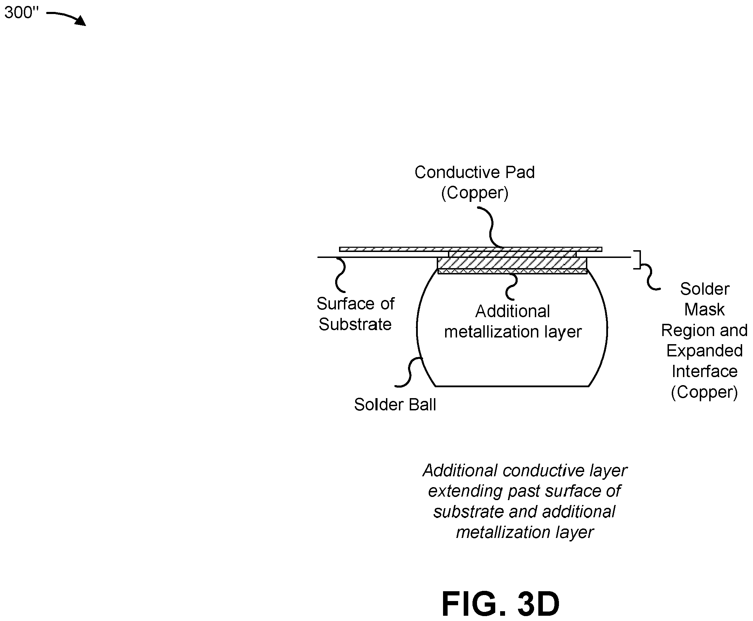

As shown in Fig. 3D, and in example 300", during manufacture of another implementation, an additional metallization layer is deposited onto the surface of the one or more conductive layers. For example, a nickel layer may be deposited onto copper conductive layers. Additionally, or alternatively, another one or more materials may be deposited onto one or more copper conductive layers, such as zinc, aluminum, gold, silver, platinum, or an alloy thereof, among other examples. In some implementations, the additional metallization layer may be associated with a thickness of approximately 20 µm or in a range of approximately 0.1 µm to approximately 20 µm. In some implementations, the additional metallization layer may have a thickness of approximately 100% of a thickness of the one or more conductive layers. In some implementations, multiple additional metallization layers may be provided (e.g., multiple layers of the same material or multiple layers of different materials). By adding an additional metallization layer, additional current spreading may be achieved, thereby further reducing electromigration. Moreover, the additional metallization layer may provide additional properties, such as higher resistance to electromigration from a level of current density still present, further resistance to electromigration-induced failure, resistance to environmental conditions, improvement in processing control (e.g., ensuring that solder joints have consistent dimensions during manufacture), or improvement of a connection between the conductive pad and the solder ball, among other examples.

As indicated above, Figs. 3A-3D are provided as one or more examples. Other examples may differ from what is described with regard to Figs. 3A-3D.

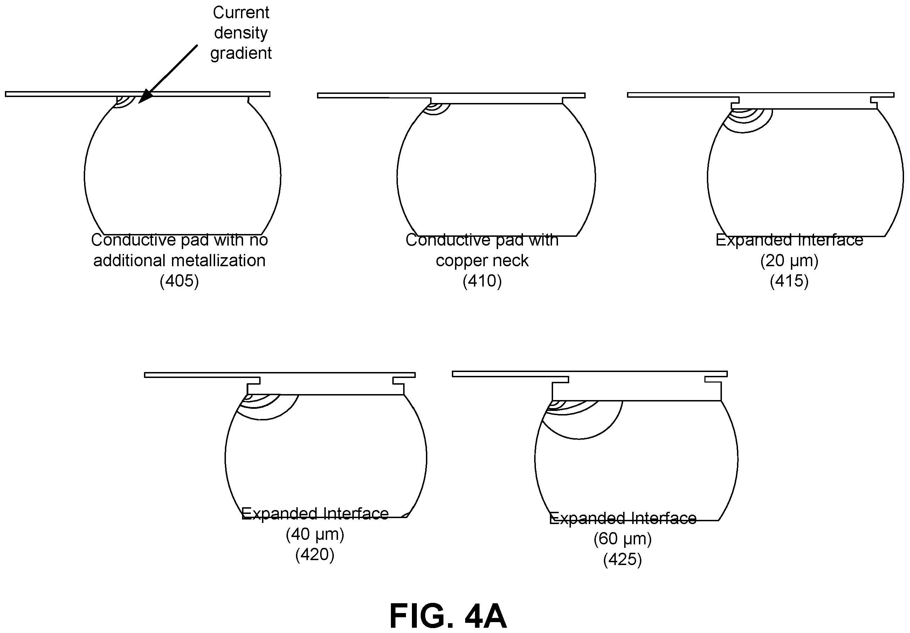

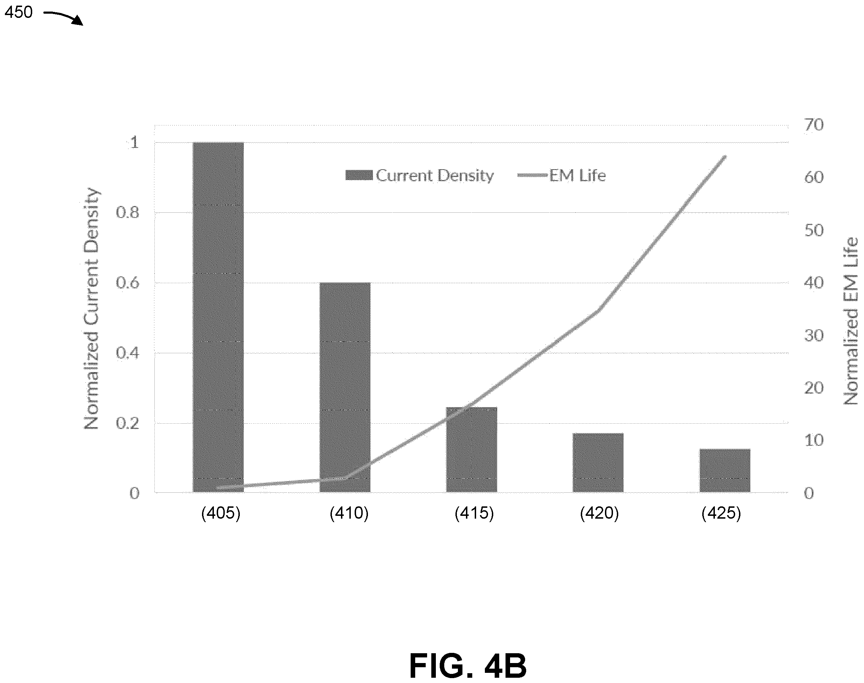

Figs. 4A-4B are diagrams of examples 405-425 and a diagram 450 of characteristics of a conductive pad and a conductive layer. As shown in Figs. 4A-4B, an example 405 of a conductive pad with no additional metallization may have a relatively high current density, normalized to a value of 1, and a relatively low electromigration (EM) life (e.g., an average amount of time before electromigration-induced failure), normalized to a value of 1, as shown in Fig. 4B. In comparison, an example 410 of a conductive pad with a copper neck (e.g., filling the solder mask region) may have a current density that is approximately 40% lower than that of example 405 and a normalized EM life that is normalized to a value of approximately 3 relative to example 405. In this case, adding a single conductive layer significantly reduces current density and improves EM life.

Similarly, examples 415 (of an implementation with a second conductive layer with a 20 µm thickness), 420 (of an implementation with a second conductive layer with a 40 µm thickness), and 425 (of an implementation with a second conductive layer with a 60 µm thickness) exhibit further reductions in normalized current density (reductions of approximately 75%, approximately 85%, and approximately 90% respectively) and improvements in EM life (to normalized values of approximately 15, approximately 35, and approximately 65, respectively) relative to example 405. In this case, adding additional thickness to one or more conductive layers (e.g., forming a thicker monolithic conductive layer or forming multiple conductive layers) further reduces a likelihood of electromigration-induced failure.

As indicated above, Figs. 4A-4B are provided as an example. Other examples may differ from what is described with regard to Figs. 4A-4B.

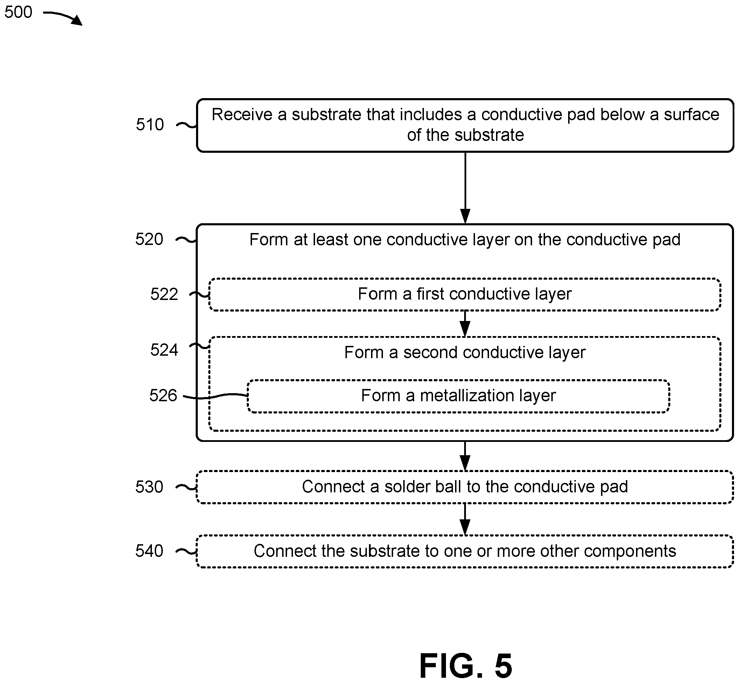

Fig. 5 is a flowchart of an example process 500 for providing a semiconductor device pad configuration that improves electromigration performance of the semiconductor device. In some implementations, one or more process blocks of Fig. 5 may be performed by a manufacturing device (e.g., a metallization device, a plating device, a deposition device, a masking device, or an etching device, among other examples).

As shown in Fig. 5, process 500 may include receiving a substrate that includes a conductive pad below a surface of the substrate (block 510). For example, a manufacturing device may receive a substrate that includes a conductive pad below a surface of the substrate, as described above. In some implementations, the manufacturing device may form the conductive pad below the surface of the substrate.

As further shown in Fig. 5, process 500 may include forming at least one conductive layer on the conductive pad, wherein the at least one conductive layer extends to at least the surface of the substrate, and wherein a solder ball is connectable to the at least one conductive layer (block 520). For example, a manufacturing device may form at least one conductive layer on the conductive pad, as described above. In some implementations, the at least one conductive layer extends to at least the surface of the substrate. In some implementations, a solder ball is connectable to the at least one conductive layer.

As further shown in Fig. 5, process 500 may optionally include forming a first conductive layer (block 522) and forming a second conductive layer (block 524). For example, when forming at least one conductive layer on the conductive pad, a manufacturing device may form a first conductive layer and a second conductive layer.

As further shown in Fig. 5, process 500 may optionally include forming a metallization layer (block 526). For example, when forming the second conductive layer, the manufacturing device may form a metallization layer as the second conductive layer. Additionally, or alternatively, the manufacturing device may form a metallization layer to at least partially cover the second conductive layer or to cover the second conductive layer in an entirety. In some implementations, the metallization layer may partially cover the surface of the substrate.

As further shown in Fig. 5, process 500 may optionally include connecting a solder ball to the conductive pad (block 530). For example, a manufacturing device may connect a solder ball to the conductive pad by attaching the solder ball to the at least one conductive layer.

As further shown in Fig. 5, process 500 may optionally include connecting the substrate to one or more other components (block 540). For example, a manufacturing device may connect the substrate to another component by connecting the solder ball to the other component. Additionally, or alternatively, the manufacturing device may connect another side of the substrate to another component. For example, one or more manufacturing devices may connect the substrate to a first electrical component on a first side of the substrate and to a second electrical component on a second side of the substrate.

Process 500 may include additional implementations, such as any single implementation or any combination of implementations described below and/or in connection with one or more other processes described elsewhere herein.

In a first implementation, forming the at least one conductive layer comprises forming a first conductive layer that extends to the surface of the substrate, and forming a second conductive layer on the first conductive layer, wherein the solder ball is connectable to the second conductive layer.

In a second implementation, alone or in combination with the first implementation, forming the at least one conductive layer comprises forming a first conductive layer that extends to the surface of the substrate, forming a second conductive layer on the first conductive layer, and forming a metallization layer on the second conductive layer, wherein the metallization layer is a different type of material than the first conductive layer and the second conductive layer.

In a third implementation, alone or in combination with one or more of the first and second implementations, forming the at least one conductive layer comprises forming a first conductive layer that extends to the surface of the substrate, and forming a second conductive layer on the first conductive layer and on at least a portion of the surface of the substrate, wherein the solder ball is connectable to the second conductive layer.

In a fourth implementation, alone or in combination with one or more of the first through third implementations, process 500 includes connecting a memory or an integrated circuit to another surface of the substrate.

In a fifth implementation, alone or in combination with one or more of the first through fourth implementations, process 500 includes connecting a printed circuit board to the surface of the substrate using the solder ball.

In a sixth implementation, alone or in combination with one or more of the first through fifth implementations, process 500 includes connecting the solder ball to the at least one conductive layer.

In a seventh implementation, alone or in combination with one or more of the first through sixth implementations, the at least one conductive layer diffuses a flow of current between the substrate and the solder ball.

In an eighth implementation, alone or in combination with one or more of the first through seventh implementations, the at least one conductive layer reduces a current density at an interface between the substrate and the solder ball.

In a ninth implementation, alone or in combination with one or more of the first through eighth implementations, forming the at least one conductive layer comprises forming the at least one conductive layer using at least one of a metallization procedure, a plating procedure, or a deposition procedure.

In a tenth implementation, alone or in combination with one or more of the first through ninth implementations, the conductive pad is formed in a solder mask region that has a volume with a depth and a width, and wherein forming the at least one conductive layer comprises filling the volume of the solder mask region with the at least one conductive layer.

In an eleventh implementation, alone or in combination with one or more of the first through tenth implementations, the conductive pad is formed in a solder mask region that has a volume with a depth and a width, and wherein forming the at least one conductive layer comprises substantially filling the volume of the solder mask region with the at least one conductive layer.

In a twelfth implementation, alone or in combination with one or more of the first through eleventh implementations, the conductive pad is formed in a solder mask region that has a volume with a depth and a width, and wherein forming the at least one conductive layer comprises filling the volume of the solder mask region with a first material of the at least one conductive layer, and depositing a second material of the at least one conductive layer on the first material, wherein the second material covers a surface of the first material.

In a thirteenth implementation, alone or in combination with one or more of the first through twelfth implementations, the second material covers the surface of the first material and at least a portion of the surface of the substrate.

In a fourteenth implementation, alone or in combination with one or more of the first through thirteenth implementations, the at least one conductive layer impacts a flow of current between the substrate and the solder ball.

In a fifteenth implementation, alone or in combination with one or more of the first through fourteenth implementations, the at least one conductive layer has a thickness in a range from approximately 5 to approximately 60 micrometers.

In a sixteenth implementation, alone or in combination with one or more of the first through fifteenth implementations, the at least one conductive layer includes a first layer with a thickness in a range from approximately 5 micrometers to approximately 60 micrometers and a second layer with a thickness in a range from approximately 20 micrometers to approximately 60 micrometers.

In a seventeenth implementation, alone or in combination with one or more of the first through sixteenth implementations, the at least one conductive layer includes a first layer and a second layer, the second layer having a thickness in a range from approximately 0% to approximately 200% greater than a thickness of the first layer.

Although Fig. 5 shows example blocks of process 500, in some implementations, process 500 may include additional blocks, fewer blocks, different blocks, or differently arranged blocks than those depicted in Fig. 5. Additionally, or alternatively, two or more of the blocks of process 500 may be performed in parallel.

The foregoing disclosure provides illustration and description but is not intended to be exhaustive or to limit the implementations to the precise form disclosed. Modifications may be made in light of the above disclosure or may be acquired from practice of the implementations.

Certain aspects have been described in terms of approximate values. An approximate value may, depending on the context, include values within +/-10% of the stated approximate value.

Spatially relative terms, such as "beneath," "below," "lower," "above," "upper," among other examples, have been used to describe one component or feature's relationship to another component or feature as illustrated in the figures. The spatially relative terms are intended to encompass different orientations of a device in use or operation in addition to the orientation depicted in the figures. The device may be otherwise oriented (e.g., flipped top-to-bottom, rotated 90 or 270 degrees, or changed to other orientations) and the spatially relative terms used herein may likewise be interpreted accordingly.

Although particular combinations of features are recited in the claims and/or disclosed in the specification, these combinations are not intended to limit the disclosure of various implementations. In fact, many of these features may be combined in ways not specifically recited in the claims and/or disclosed in the specification. Although each dependent claim listed below may directly depend on only one claim, the disclosure of various implementations includes each dependent claim in combination with every other claim in the claim set.

No element, act, or instruction used herein should be construed as critical or essential unless explicitly described as such. Also, as used herein, the articles "a" and "an" are intended to include one or more items and may be used interchangeably with "one or more." Further, as used herein, the article "the" is intended to include one or more items referenced in connection with the article "the" and may be used interchangeably with "the one or more." Furthermore, as used herein, the term "set" is intended to include one or more items (e.g., related items, unrelated items, a combination of related and unrelated items, and/or the like), and may be used interchangeably with "one or more." Where only one item is intended, the phrase "only one" or similar language is used. Also, as used herein, the terms "has," "have," "having," or the like are intended to be open-ended terms. Further, the phrase "based on" is intended to mean "based, at least in part, on" unless explicitly stated otherwise. Also, as used herein, the term "or" is intended to be inclusive when used in a series and may be used interchangeably with "and/or," unless explicitly stated otherwise (e.g., if used in combination with "either" or "only one of').

Thus, from one perspective there has been described a substrate structure that may include a substrate that includes a set of conductive pads formed below a surface of the substrate. The substrate structure may include a set of conductive layer portions formed over the set of conductive pads, wherein a particular conductive layer portion, of the set of conductive layer portions, extends from a corresponding particular conductive pad, of the set of conductive pads, to at least the surface of the substrate.

Examples of the present disclosure are set out in the following numbered clauses:
1. A substrate structure, comprising:
   a substrate that includes a set of conductive pads formed below a surface of the substrate; and
   a set of conductive layer portions formed over the set of conductive pads, wherein a particular conductive layer portion, of the set of conductive layer portions, extends from a corresponding particular conductive pad, of the set of conductive pads, to at least the surface of the substrate.
2. The substrate structure of clause 1, further comprising:
   a set of electrical traces connected to the set of conductive pads, wherein a particular electrical trace, of the set of electrical traces, is oriented in approximately a first plane, and
   wherein the particular conductive layer portion extends in a direction orthogonal to the first plane.
3. The substrate structure of clause 1 or clause 2, wherein the particular conductive layer portion comprises a first material, and
   wherein the particular conductive layer portion is to connect to a corresponding solder ball comprising a second material that is different from the first material.
4. The substrate structure of clause 3, wherein the first material is associated with a higher electrical conductivity than the second material.
5. The substrate structure of clause 3, wherein the first material is associated with a higher resistance to electromigration than the second material.
6. The substrate structure of any preceding clause, wherein the particular conductive layer portion covers an entirety of a surface of the corresponding particular conductive pad.
7. The substrate structure of any preceding clause, wherein the particular conductive layer portion covers the corresponding particular conductive pad and at least a portion of the surface of the substrate.
8. The substrate structure of any preceding clause, wherein a thickness of the particular conductive layer portion is equal to a depth of the corresponding particular conductive pad below the surface of the substrate.
9. The substrate structure of any of clauses 1 to 7, wherein a thickness of the particular conductive layer portion is greater than a depth of the corresponding particular conductive pad below the surface of the substrate.
10. The substrate structure of any preceding clause, wherein a thickness of the particular conductive layer portion is in a range from approximately 0% to approximately 200% thicker than a depth of the corresponding particular conductive pad below the surface of the substrate.
11. A substrate structure, comprising:
   a substrate with a set of electrical traces disposed below a surface of the substrate,
      wherein the substrate includes a set of solder mask regions extending from the set of electrical traces to the surface of the substrate; and
   a set of conductive layer portions filling the set of solder mask regions toward the surface of the substrate and electrically connected to the set of electrical traces.
12. The substrate structure of clause 11, wherein a conductive layer portion, of the set of conductive layer portions, comprises a single, monolithic material.
13. The substrate structure of clause 11, wherein a conductive layer portion, of the set of conductive layer portions, comprises a plurality of layers of a single material.
14. The substrate structure of clause 11, wherein a conductive layer portion, of the set of conductive layer portions, comprises a first conductive layer of a first material and a second conductive layer of a second material covering the first conductive layer of the first material.
15. The substrate structure of any of clauses 11 to 14, wherein the set of conductive layer portions includes at least one of:
   a copper material,
   a nickel material, or
   an alloy material.
16. The substrate structure of any of clauses 11 to 15, further comprising:
   a set of solder balls connected to the set of conductive layer portions.
17. The substrate structure of any of clauses 11 to 16, wherein the set of conductive layer portions partially fill the set of solder mask regions.
18. A device, comprising:
   a substrate structure including a substrate with a first set of solder balls,
      wherein the substrate structure includes a set of conductive pads formed below a first surface of the substrate, and
      wherein the substrate structure includes a set of conductive layer portions formed over the set of conductive pads, extending from the set of conductive pads to at least the first surface of the substrate, and to which the first set of solder balls is connected; and
   an integrated circuit mounted to a second surface of the substrate structure using a second set of solder balls.
19. The device of clause 18, wherein the substrate structure further comprises:
   a set of electrical traces below the first surface of the substrate and in a plane parallel to the first surface and the second surface,
   wherein the set of electrical traces is electrically connected to the first set of solder balls using the set of conductive pads and the set of conductive layer portions.
20. The device of clause 18 or clause 19, wherein the substrate structure further comprises:
   a set of vias disposed in the substrate to electrically connect the first set of solder balls and the second set of solder balls.

## Claims

1. A substrate structure, comprising:
a substrate that includes a set of conductive pads formed below a surface of the substrate; and
a set of conductive layer portions formed over the set of conductive pads, wherein a particular conductive layer portion, of the set of conductive layer portions, extends from a corresponding particular conductive pad, of the set of conductive pads, to at least the surface of the substrate.

2. The substrate structure of claim 1, further comprising:
a set of electrical traces connected to the set of conductive pads, wherein a particular electrical trace, of the set of electrical traces, is oriented in approximately a first plane, and
wherein the particular conductive layer portion extends in a direction orthogonal to the first plane.

3. The substrate structure of claim 1 or claim 2, wherein the particular conductive layer portion comprises a first material, and
wherein the particular conductive layer portion is to connect to a corresponding solder ball comprising a second material that is different from the first material.

4. The substrate structure of claim 3, wherein the first material is associated with at least one of:
a higher electrical conductivity than the second material; and
a higher resistance to electromigration than the second material.

5. The substrate structure of any preceding claim, wherein the particular conductive layer portion covers an entirety of a surface of the corresponding particular conductive pad, and optionally wherein the particular conductive layer portion covers at least a portion of the surface of the substrate.

6. The substrate structure of any preceding claim, wherein a thickness of the particular conductive layer portion is equal to a depth of the corresponding particular conductive pad below the surface of the substrate.

7. The substrate structure of any of claims 1 to 5, wherein a thickness of the particular conductive layer portion is greater than a depth of the corresponding particular conductive pad below the surface of the substrate, and optionally is in a range from 0% to approximately 200% thicker than the depth of the corresponding particular conductive pad below the surface of the substrate.

8. A substrate structure, comprising:
a substrate with a set of electrical traces disposed below a surface of the substrate,
wherein the substrate includes a set of solder mask regions extending from the set of electrical traces to the surface of the substrate; and
a set of conductive layer portions filling the set of solder mask regions toward the surface of the substrate and electrically connected to the set of electrical traces.

9. The substrate structure of claim 8, wherein a conductive layer portion, of the set of conductive layer portions, comprises a single, monolithic material.

10. The substrate structure of claim 8, wherein a conductive layer portion, of the set of conductive layer portions, comprises a plurality of layers of a single material.

11. The substrate structure of claim 8, wherein a conductive layer portion, of the set of conductive layer portions, comprises a first conductive layer of a first material and a second conductive layer of a second material covering the first conductive layer of the first material.

12. The substrate structure of any of claims 8 to 11, wherein the set of conductive layer portions partially fill the set of solder mask regions.

13. A device, comprising:
a substrate structure including a substrate with a first set of solder balls,
wherein the substrate structure includes a set of conductive pads formed below a first surface of the substrate, and
wherein the substrate structure includes a set of conductive layer portions formed over the set of conductive pads, extending from the set of conductive pads to at least the first surface of the substrate, and to which the first set of solder balls is connected; and
an integrated circuit mounted to a second surface of the substrate structure using a second set of solder balls.

14. The device of claim 13, wherein the substrate structure further comprises:
a set of electrical traces below the first surface of the substrate and in a plane parallel to the first surface and the second surface,
wherein the set of electrical traces is electrically connected to the first set of solder balls using the set of conductive pads and the set of conductive layer portions.

15. The device of claim 18 or claim 19, wherein the substrate structure further comprises:
a set of vias disposed in the substrate to electrically connect the first set of solder balls and the second set of solder balls.
